# EUROPEAN PATENT APPLICATION

(11) **EP 4 044 258 A1**
(43) Date of publication of application: **17.08.2022**
(21) Application number: 20885230.1
(22) Date of filing: 12.06.2020
(51) Int. Cl.: H01L 31/0216, H01L 31/0224, H01L 31/042, H01L 31/18

(54) **PHOTOVOLTAIC CELL AND PREPARATION METHOD THEREFOR**

(30) Priority: 05.11.2019 CN 201911072931
(71) Applicant: Longi Solar Technology (Taizhou) Co., Ltd., Taizhou, Jiangsu 225300 (CN)
(72) Inventor: ZHU, Chen, Taizhou, Jiangsu 225300 (CN); YUAN, Yunlai, Taizhou, Jiangsu 225300 (CN); WANG, Jianbo, Taizhou, Jiangsu 225300 (CN); LU, Jun, Taizhou, Jiangsu 225300 (CN)
(74) Representative: Manitz Finsterwald Patent- und Rechtsanwaltspartnerschaft mbB
(86) International application number: PCT/CN2020/095746
(87) International publication number: WO 2021/088369

(57) **Abstract**

The embodiments of the present disclosure provide a photovoltaic cell and a fabricating method of the photovoltaic cell. The photovoltaic cell includes: a substrate layer; an emitter layer , characterized in that, the emitter layer is provided at a first face of the substrate layer ;a plurality of front-face metal grid lines, wherein the plurality of front-face metal grid lines are provided in parallel at the side of the emitter layer that is away from the substrate layer; and a plurality of diffuse-reflection layers, wherein the plurality of diffuse-reflection layers are provided individually at the side of each of the front-face metal grid lines that are away from the emitter layer, and the diffuse-reflection layers are in correspondence with the front-face metal grid lines one to one. The embodiments of the present disclosure, by providing the diffuse-reflection layers on the front-face metal grid lines, increase the diffuse reflection of the light emitting the front-face metal grid lines, whereby more light emit the emitter layer of the photovoltaic cell, which increases the absorptivity of the light. Furthermore, the diffuse-reflection layers are provided merely on the front-face metal grid lines, and do not block the light emitting the emitter layer.

## Description

The present application claims the priority of the Chinese patent application filed on November 5th, 2019 before the Chinese Patent Office with the application number of 201911072931.1 and the title of "PHOTOVOLTAIC CELL AND PREPARATION METHOD THEREFOR", which is incorporated herein in its entirety by reference.

### TECHNICAL FIELD

The present disclosure relates to the technical field of solar cells, and particularly relates to a photovoltaic cell and a fabricating method thereof.

### BACKGROUND

In order to obtain a photovoltaic conversion efficiency as high as possible, front-face metal grid lines and back-face metal grid lines are needed to be fabricated on a photovoltaic cell, to lead the electric currents in the photovoltaic cell to out of the cell. The front-face metal grid lines refer to the electrically conductive metal lines provided at the light collecting face of the photovoltaic cell, and the back-face metal grid lines refer to the electrically conductive metal lines provided at the shadow face of the photovoltaic cell.

Conventionally, the front-face metal grid lines shield the lights of the light collecting face of the photovoltaic cell, and the area of the light shielding is up to 40%, which reduces the light-absorption efficiency of the photovoltaic cell. In another aspect, conventionally, the commonly used front-face metal grid lines are a silver metal material, but the surface of the silver metal material is smooth, and has a poor diffuse reflection ability of the light, and the scattering coefficient of the incident lights is only 0.15-0.2. As a result, the light emitting the front-face metal grid lines cannot be re-absorbed by the photovoltaic cell, which reduces the light-absorption efficiency of the photovoltaic cell.

### SUMMARY

The present disclosure provides a photovoltaic cell, to solve the problem of a low light-absorption efficiency of current photovoltaic cells.

An aspect of the present disclosure provides a photovoltaic cell, characterized in that, the photovoltaic cell comprises:
a substrate layer;
an emitter layer, characterized in that, the emitter layer is provided at a first face of the substrate layer;
a plurality of front-face metal grid lines, wherein the plurality of front-face metal grid lines are provided in parallel at the side of the emitter layer that is away from the substrate layer ; and
a plurality of diffuse-reflection layers , wherein the plurality of diffuse-reflection layers are provided individually at the side of each of the front-face metal grid lines that are away from the emitter layer, and the diffuse-reflection layers are in correspondence with the front-face metal grid lines one to one.

Optionally, a side of the diffuse-reflection layers that are away from the front-face metal grid lines have protrusions and depressions.

Optionally, a material of the diffuse-reflection layers is a mixture of a photosensitive adhesive and a metal powder.

Optionally, the metal powder comprises one or more of a silver powder, an aluminum powder, a nickel powder and a titanium dioxide.

Optionally, mass percentages of the metal powders in the diffuse-reflection layers include: 13%-15% of the silver powder, 13%-25% of the aluminum powder, 4%-20% of the nickel powder and 9%-12% of the titanium dioxide.

Optionally, width of the front-face metal grid lines that is covered by the diffuse-reflection layers is not greater than width of the front-face metal grid lines.

Another aspect of the embodiments of the present disclosure provides a fabricating method of a photovoltaic cell, characterized in that, the method comprises:
providing a substrate layer, and washing the substrate layer;
forming an emitter layer at a first face of the substrate layer;
forming a plurality of front-face metal grid lines in parallel at a side of the emitter layer that is away from the substrate layer;
placing a halftone at a side of each of the front-face metal grid lines that are away from the emitter layer, and printing a diffuse-reflection-layer adhesive material by screen printing; and
irradiating the diffuse-reflection-layer adhesive material with an ultraviolet light, to solidify the diffuse-reflection-layer adhesive material, to obtain a plurality of diffuse-reflection layers, characterized in that, the diffuse-reflection layers are in correspondence with the front-face metal grid lines one to one.

Optionally, an opening width of the halftone is less than a width of each of the front-face metal grid lines.

Optionally, a mesh number of the halftone is 300 meshes to 400 meshes;
a thickness of the halftone is 15µm-20µm; and
an opening width of the halftone is 15µm-25µm.

Optionally, an irradiation duration of the ultraviolet light is 5 minutes to 10 minutes.

The photovoltaic cell according to an embodiment of the present disclosure comprises: a substrate layer; an emitter layer, wherein the emitter layer is provided at a first face of the substrate layer; a plurality of front-face metal grid lines, wherein the plurality of front-face metal grid lines are provided in parallel at a side of the emitter layer that is away from the substrate layer; and a plurality of diffuse-reflection layers, wherein the plurality of diffuse-reflection layers are provided individually at a side of each of the front-face metal grid lines that are away from the emitter layer, and the diffuse-reflection layers are in correspondence with the front-face metal grid lines one to one. The embodiments of the present disclosure, by providing the diffuse-reflection layers on the front-face metal grid lines, increase the diffuse reflection of the light emitting the front-face metal grid lines, whereby more light emit the emitter layer of the photovoltaic cell, which increases the absorptivity of the light. Furthermore, the diffuse-reflection layers are provided merely on the front-face metal grid lines, and do not block the light emitting the emitter layer.

The above description is merely a summary of the technical solutions of the present disclosure. In order to more clearly know the elements of the present disclosure to enable the implementation according to the contents of the description, and in order to make the above and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure, the figures that are required to describe the embodiments of the present disclosure will be briefly introduced below. Apparently, the figures that are described below are embodiments of the present disclosure, and a person skilled in the art can obtain other figures according to these figures without paying creative work.
FIG. 1 schematically shows a schematic structural diagram of the photovoltaic cell according to an embodiment of the present disclosure;
FIG. 2 schematically shows a schematic structural diagram of the morphology of the diffuse-reflection layer according to an embodiment of the present disclosure; and
FIG. 3 schematically shows a flow chart of the steps of the fabricating method of a photovoltaic cell according to an embodiment of the present disclosure.

### DETAILED DESCRIPTION

The technical solutions of the embodiments of the present disclosure will be clearly and completely described below with reference to the drawings of the embodiments of the present disclosure. Apparently, the described embodiments are merely certain embodiments of the present disclosure, rather than all of the embodiments. All of the other embodiments that a person skilled in the art obtains on the basis of the embodiments of the present disclosure without paying creative work fall within the protection scope of the present disclosure.

The first embodiment

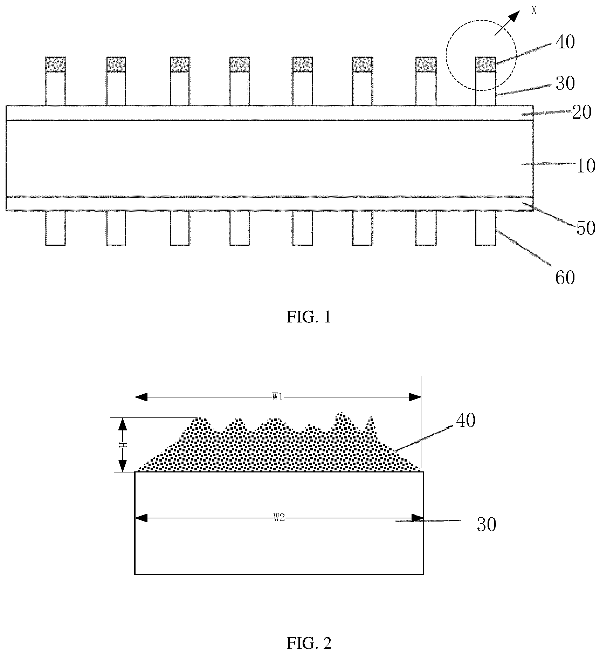

Referring to FIG. 1, a photovoltaic cell is shown. The photovoltaic cell comprises:
a substrate layer 10;
an emitter layer 20, wherein the emitter layer 20 is provided at a first face of the substrate layer 10;
a plurality of front-face metal grid lines 30, wherein the plurality of front-face metal grid lines 30 are provided in parallel at the side of the emitter layer 20 that is away from the substrate layer 10; and
a plurality of diffuse-reflection layers 40, wherein the plurality of diffuse-reflection layers 40 are provided individually at the side of each of the front-face metal grid lines 30 that are away from the emitter layer, and the diffuse-reflection layers 40 are in correspondence with the front-face metal grid lines 30 one to one.

In an embodiment of the present disclosure, the photovoltaic cell further comprises a back-field layer 50 and back-face metal grid lines 60. The back-field layer 50 is provided at a second face of the substrate layer 10 that is opposite to the first face. The back-face metal grid lines 60 are provided at the side of the back-field layer that is away from the substrate layer 10. The plurality of back-face metal grid lines are arranged separately in parallel.

In an embodiment of the present disclosure, the material of the substrate layer 10 is a silicon material.

In the embodiments of the present disclosure, the front-face metal grid lines 30 refer to the metal grid lines provided at the light collecting side of the photovoltaic cell, and the back-face metal grid lines 60 refer to the metal grid lines provided at the shadow side of the photovoltaic cell.

In an embodiment of the present disclosure, referring to FIG. 2, an enlarged view of the region X in FIG. 1 is shown. The side of each of the diffuse-reflection layers 40 that are away from the front-face metal grid lines 30 have a plurality of protrusions and depressions, not smooth planes. Those protrusions and depressions may be microstructures. In other words, the side of each of the diffuse-reflection layers 40 that are away from the front-face metal grid lines 30 are uneven.

In other words, the side of each of the diffuse-reflection layers 40 that are away from the front-face metal grid lines 30 are uneven, the side may refer to knap surfaces, i.e., rough surfaces. A rough surface, as a frequently used term in the art, is named as compared with a smooth surface, wherein the roughness of the rough surface is greater than the roughness of the smooth surface. The particular numerical value of the roughness is not limited in the present disclosure. The rough surfaces can increase the diffuse reflection of the light by the diffuse-reflection layers, to increase the absorbance of the photovoltaic cell.

In an embodiment of the present disclosure, the photovoltaic cell in FIG. 1 further comprises an encapsulating cover plate. Generally, the encapsulating cover plate encircles the photovoltaic cell shown in FIG. 1, and the encapsulating cover plate comprises a glass material. After the light have been diffusively reflected at the diffuse-reflection layers 40, the light emit the encapsulating cover plate are reflected by the encapsulating cover plate, and emit the emitter layer 20, so that the light are absorbed by the photovoltaic cell, to increase the absorbance of the photovoltaic cell.

In an embodiment of the present disclosure, the material of the diffuse-reflection layers 40 is a mixture of a photosensitive adhesive and a metal powder.

In the embodiments of the present disclosure, the photosensitive adhesive (UV adhesive) is also referred to a shadowless glue or an ultraviolet-light-solidified adhesive. The shadowless glue is a type of adhesives that can be cured merely by ultraviolet-light irradiation, and it may be used as a bonding agent. The principle of the solidification of the shadowless glue includes that the photoinitiator (or photosensitizer) in an UV cured material, under the irradiation by an ultraviolet ray, absorbs the ultraviolet light and generates active free radicals or cations, to initiate monomer polymerization and cross-linking reaction, whereby the adhesive is converted from a liquid state into a solid state within several seconds.

The photosensitive adhesive is an insulating material, so the diffuse-reflection layers obtained by mixing the photosensitive adhesive and the metal powder are also an insulating material, and thus the electric conductivity of the front-face metal grid lines does not be influenced.

In an embodiment of the present disclosure, the metal powder comprises one or more of a silver powder, an aluminum powder, a nickel powder and a titanium dioxide.

In an embodiment of the present disclosure, the metal powders are micrometer-sized particles; in other words, the range of the particle sizes of the metal powders is 1µm-100µm.

In an embodiment of the present disclosure, the metal powders are mixed uniformly and then mixed with the photosensitive adhesive, to obtain the material for fabricating the diffuse-reflection layers.

In an embodiment of the present disclosure, the mass percentages of the metal powders in the diffuse-reflection layers 40 include: 13%-15% of the silver powder, 13%-25% of the aluminum powder, 4%-20% of the nickel powder and 9%-12% of the titanium dioxide.

In the embodiments of the present disclosure, the mass proportions of the metal powders in the diffuse-reflection layers may be regulated according to practical demands, which is not limited herein.

In an embodiment of the present disclosure, the diffuse-reflection layers 40 are an insulating material.

In an embodiment of the present disclosure, the diffuse-reflection layers 40 and the front-face metal grid lines 30 do not react with each other.

In an embodiment of the present disclosure, the scattering coefficient of the side of each of the diffuse-reflection layers 40 that are away from the front-face metal grid lines 30 is greater than 0.6.

In an embodiment of the present disclosure, it is required that the diffuse-reflection layers and the front-face metal grid lines do not react with each other, and when the front-face metal grid lines are silver, the diffuse-reflection layers do not react with silver. At the same time, the diffuse-reflection layers are required to be an insulating material, so as not to change the line resistance of the front-face metal grid lines, and have no influence on the conducting power of the front-face metal grid lines.

In an embodiment of the present disclosure, referring to FIG. 2, the thickness H of the diffuse-reflection layers is 5µm-15µm.

In an embodiment of the present disclosure, referring to FIG. 2, the width W1 of the front-face metal grid line 30 that is covered by the diffuse-reflection layer 40 is not greater than the width W2 of the front-face metal grid line 30.

Referring to FIG. 2, in an embodiment of the present disclosure, the thicknesses of the edge regions on the two sides of the diffuse-reflection layer are less than the thickness of the middle region, and the thicknesses gradually increase from the edge region to the middle region.

When the width W1 of the front-face metal grid line 30 is not greater than the width W2 of the front-face metal grid line 30, the diffuse-reflection layers 40 do not block the incidence of the light to the emitter layer 20.

The photovoltaic cell according to an embodiment of the present disclosure comprises: a substrate layer; an emitter layer, wherein the emitter layer is provided at a first face of the substrate layer; a plurality of front-face metal grid lines, wherein the plurality of front-face metal grid lines are provided in parallel at a side of the emitter layer that is away from the substrate layer; and a plurality of diffuse-reflection layers, wherein the plurality of diffuse-reflection layers are provided individually at a side of each of the front-face metal grid lines that are away from the emitter layer, and the diffuse-reflection layers are in correspondence with the front-face metal grid lines one to one. The embodiments of the present disclosure, by providing the diffuse-reflection layers on the front-face metal grid lines, increase the diffuse reflection of the light emitting the front-face metal grid lines, whereby more light emit the emitter layer of the photovoltaic cell, which increases the absorptivity of the light. Furthermore, the diffuse-reflection layers are provided merely on the front-face metal grid lines, and do not block the light emitting the emitter layer.

The second embodiment

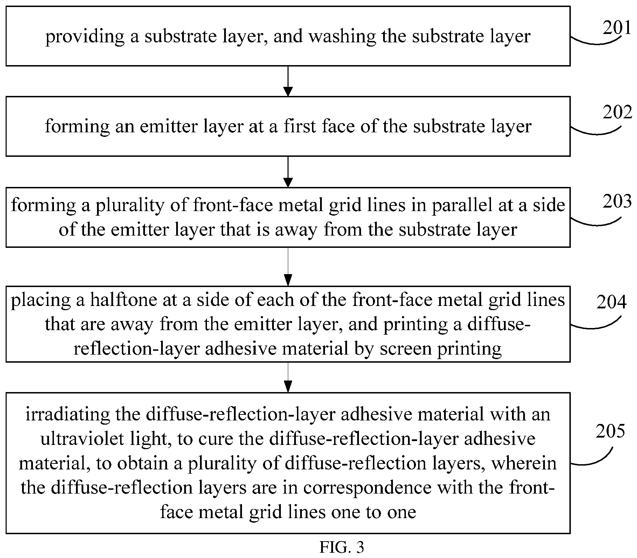

Referring to FIG. 3, a flow chart of the steps of the fabricating method of a photovoltaic cell according to an embodiment of the present disclosure is shown. The method comprises:
Step 201: providing a substrate layer, and washing the substrate layer.

In an embodiment of the present disclosure, the material of the substrate layer 10 is a silicon material. The silicon substrate is washed. The washing comprises ultrasonic washing and deionized-water washing.

Step 202: forming an emitter layer at a first face of the substrate layer.

In an embodiment of the present disclosure, the emitter layer is formed at the first face of the substrate layer by means of diffusion.

In an embodiment of the present disclosure, after the emitter layer has been fabricated, the method further comprises performing back-face etching to the second face of the substrate layer, subsequently fabricating a back-field layer at the second face of the substrate layer, and fabricating a passivation layer at the emitter layer and the back-field layer.

Step 203: forming a plurality of front-face metal grid lines in parallel at a side of the emitter layer that is away from the substrate layer.

In an embodiment of the present disclosure, the material of the front-face metal grid lines is silver, and the front-face metal grid lines are fabricated by screen printing, wherein the plurality of front-face metal grid lines are arranged separately in parallel.

After the step 203, the back-face metal grid lines are fabricated by the same method as that used for fabricating the front-face metal grid lines.

Step 204: placing a halftone at a side of each of the front-face metal grid lines that are away from the emitter layer, and printing a diffuse-reflection-layer adhesive material by screen printing.

In an embodiment of the present disclosure, before the step 204, a diffuse-reflection-layer adhesive material is firstly fabricated. The fabrication of the diffuse-reflection-layer adhesive material comprises: Mixing micron-sized silver powder, aluminum powder, nickel powder and titanium dioxide at a preset proportion, subsequently mixing with the photosensitive adhesive, and stirring uniformly, to obtain the diffuse-reflection-layer adhesive material.

In an embodiment of the present disclosure, an opening width of the halftone is less than a width of each of the front-face metal grid lines.

The opening width of the halftone is less than the width of each of the front-face metal grid lines, whereby, the diffuse-reflection-layer adhesive material will not be missed on both sides of the front-face metal grid lines during screen printing, so as to prevent the diffuse-reflection-layer adhesive material from leaking between the front-face metal grid lines, to block the light emitting the emitter layer.

In an embodiment of the present disclosure, a mesh number of the halftone is 300 meshes to 400 meshes; a thickness of the halftone is 15µm-20µm; and an opening width of the halftone is 15µm-25µm.

In the embodiments of the present disclosure, the specification of the halftone for fabricating the diffuse-reflection layers may be regulated according to practical demands.

Step 205: irradiating the diffuse-reflection-layer adhesive material with an ultraviolet light, to cure the diffuse-reflection-layer adhesive material, to obtain a plurality of diffuse-reflection layers, wherein the diffuse-reflection layers are in correspondence with the front-face metal grid lines one to one.

In an embodiment of the present disclosure, an irradiation duration of the ultraviolet light is 5 minutes to 10 minutes.

In the embodiments of the present disclosure, generally, after the screen printing of the diffuse-reflection-layer adhesive material, the surface of the diffuse-reflection-layer adhesive material is smooth. However, under the irradiation of an ultraviolet light, the surface of the diffuse-reflection-layer adhesive material has contractions of different degrees, so that rough uneven faces are formed at the surface of the diffuse-reflection-layer adhesive material, wherein the rough surfaces can increase the diffuse reflection by the diffuse-reflection layers.

**Table 1**

| photovoltaic cell | FF (filling factor) | Isc (short -circuit -current temperature coefficient) | Voc (open-circuit-voltage temperature coefficient) | IMP (optimum operating current) | VMP (optimum operating voltage) | Pmax (maximum-pow er temperature coefficient) |
|---|---|---|---|---|---|---|
| conventional group | 79.03 % | 9.89 | 48.8 | 9.36 | 40.75 | 381.5 |
| experimental group | 79.17 % | 10.09 | 48.7 | 9.55 | 40.67 | 388.9 |

In an embodiment of the present disclosure, referring to Table 1, the measurement parameters of photovoltaic cells of different groups is shown, wherein the conventional group is the photovoltaic parameters of a conventional photovoltaic cell that is not added the diffuse-reflection layers, and the experimental group is the photovoltaic parameters of a photovoltaic cell according to an embodiment of the present disclosure that is added the diffuse-reflection layers. It can be seen that, by adding the diffuse-reflection layers, the short-circuit-current temperature coefficient of the photovoltaic cell is obviously greater than that of the conventional group. It is known from many tests that the short-circuit-current temperature coefficient of the photovoltaic cell according to an embodiment of the present disclosure is increased by above 2% as compared with the photovoltaic cell in the prior art, and the performance of the photovoltaic cell is improved.

The fabricating method of a photovoltaic cell according to an embodiment of the present disclosure comprises: providing a substrate layer, and washing the substrate layer; forming an emitter layer at a first face of the substrate layer; forming a plurality of front-face metal grid lines in parallel at a side of the emitter layer that is away from the substrate layer; placing a halftone at a side of each of the front-face metal grid lines that are away from the emitter layer, and printing a diffuse-reflection-layer adhesive material by screen printing; and irradiating the diffuse-reflection-layer adhesive material with an ultraviolet light, to cure the diffuse-reflection-layer adhesive material, to obtain a plurality of diffuse-reflection layers, wherein the diffuse-reflection layers are in correspondence with the front-face metal grid lines one to one. The photovoltaic cell fabricated by the embodiments of the present disclosure, by providing the diffuse-reflection layers on the front-face metal grid lines, the diffuse reflection of the light emitting the front-face metal grid lines is increased, whereby more light emit the emitter layer of the photovoltaic cell, so as to increase the absorptivity of the light. Furthermore, the diffuse-reflection layers are provided merely on the front-face metal grid lines, and do not block the light emitting the emitter layer.

A person skilled in the art can clearly understand that, in order for the convenience and concision of the description, the particular working processes of the above-described systems, devices and units may refer to the corresponding processes according to the above-described process embodiments, and are not discussed here further.

The above description is merely preferable embodiments of the present disclosure, and is not indented to limit the present disclosure. Any modifications, equivalent substitutions and improvements that are made within the spirit and the principle of the present disclosure should fall within the protection scope of the present disclosure.

The above are merely particular embodiments of the present disclosure, and the protection scope of the present disclosure is not limited thereto. All of the variations or substitutions that a person skilled in the art can easily envisage within the technical scope disclosed by the present disclosure should fall within the protection scope of the present disclosure. Therefore, the protection scope of the present disclosure should be subject to the protection scope of the claims.

## Claims

1. A photovoltaic cell, **characterized in that**, the photovoltaic cell comprises:
a substrate layer;
an emitter layer, **characterized in that**, the emitter layer is provided at a first face of the substrate layer;
a plurality of front-face metal grid lines , wherein the plurality of front-face metal grid lines are provided in parallel at the side of the emitter layer that is away from the substrate layer; and
a plurality of diffuse-reflection layers , wherein the plurality of diffuse-reflection layers are provided individually at the side of each of the front-face metal grid lines that are away from the emitter layer , and the diffuse-reflection layers are in correspondence with the front-face metal grid lines one to one.

2. The photovoltaic cell according to claim 1, **characterized in that**, a side of the diffuse-reflection layers that are away from the front-face metal grid lines have protrusions and depressions.

3. The photovoltaic cell according to claim 1, **characterized in that**, a material of the diffuse-reflection layers is a mixture of a photosensitive adhesive and a metal powder.

4. The photovoltaic cell according to claim 3, **characterized in that**, the metal powder comprises one or more of a silver powder, an aluminum powder, a nickel powder and a titanium dioxide.

5. The photovoltaic cell according to claim 3, **characterized in that**, mass percentages of the metal powders in the diffuse-reflection layers include: 13%-15% of the silver powder, 13%-25% of the aluminum powder, 4%-20% of the nickel powder and 9%-12% of the titanium dioxide.

6. The photovoltaic cell according to any one of claims 1-5, **characterized in that**, width of the front-face metal grid lines that is covered by the diffuse-reflection layers is not greater than width of the front-face metal grid lines .

7. A fabricating method of a photovoltaic cell, **characterized in that**, the method comprises:
providing a substrate layer, and washing the substrate layer;
forming an emitter layer at a first face of the substrate layer;
forming a plurality of front-face metal grid lines in parallel at a side of the emitter layer that is away from the substrate layer;
placing a halftone at a side of each of the front-face metal grid lines that are away from the emitter layer, and printing a diffuse-reflection-layer adhesive material by screen printing; and
irradiating the diffuse-reflection-layer adhesive material with an ultraviolet light, to cure the diffuse-reflection-layer adhesive material, to obtain a plurality of diffuse-reflection layers, **characterized in that**, the diffuse-reflection layers are in correspondence with the front-face metal grid lines correspond one to one.

8. The fabricating method according to claim 7, **characterized in that**, an opening width of the halftone is less than a width of each of the front-face metal grid lines.

9. The fabricating method according to claim 7, **characterized in that**, a mesh number of the halftone is 300 meshes to 400 meshes;
a thickness of the halftone is 15µm-20µm; and
an opening width of the halftone is 15µm-25µm.

10. The fabricating method according to claim 7, **characterized in that**, an irradiation duration of the ultraviolet light is 5 minutes to 10 minutes.
